(19) Europäisches Patentamt
European Patent Office
Office européen des brevets

(11) **EP 3 119 172 A1**

(12) **EUROPEAN PATENT APPLICATION**
published in accordance with Art. 153(4) EPC

(43) Date of publication:
**18.01.2017 Bulletin 2017/03**

(21) Application number: **15761980.0**

(22) Date of filing: **06.03.2015**

(51) Int Cl.:
*H05K 9/00* *(2006.01)*      *H05K 7/20* *(2006.01)*

(86) International application number:
**PCT/JP2015/056701**

(87) International publication number:
**WO 2015/137257 (17.09.2015 Gazette 2015/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **14.03.2014   JP 2014051840**

(71) Applicant: **Kaneka Corporation**
**Osaka-shi, Osaka 530-8288 (JP)**

(72) Inventors:
• **KOUKAMI, Aki**
**Tokyo 107-6025 (JP)**
• **NISHIURA, Koichi**
**Settsu-shi**
**Osaka 566-0072 (JP)**
• **NAKAGAKI, Takeshi**
**Tokyo 107-6025 (JP)**

(74) Representative: **Hoffmann Eitle**
**Patent- und Rechtsanwälte PartmbB**
**Arabellastraße 30**
**81925 München (DE)**

(54) **ELECTRONIC TERMINAL DEVICE AND METHOD FOR ASSEMBLING SAME**

(57)    The electronic terminal equipment comprising an electronic substrate on which a heat-generating electronic component is mounted and an electromagnetic shield member attached in proximity to the heat-generating electronic component, the electronic substrate being filled with a cured product of a thermally-conductive curable liquid resin between the electromagnetic shield member and the electronic substrate, and a thermally-conductive film being disposed in contact with an upper surface of the electromagnetic shield member or facing the upper surface thereof so as to diffuse heat that came up through the cured thermally-conductive curable liquid resin.

FIG. 4

EP 3 119 172 A1

**Description**

Technical Field

The present invention relates to electronic terminal equipment and a method for assembling the same.

Background Art

In recent years, various functions of electronic terminal equipments, such as personal computers, tablet terminals, cellular phones, smart phones, PDAs, etc., have been realized and they are due to improvements of performances of incorporated computing devices (for example, CPUs and GPUs), communication control devices (for example, base band processors), storage devices (for example, DRAMs), etc therein.

With such performance improvements of computing devices, communication control devices, storage devices, etc., the amounts of heat generated from these devices have also increased significantly and that often causes malfunction of the electronic terminal equipments.

Moreover, while performances of the computing devices, communication control devices, storage devices, etc., and amounts of generated heat are thus increasing, product packages are becoming smaller and thinner year by year, and therefore heat can hardly radiate from the electronic terminal equipments.

In light of the heat generating properties of computing devices, communication control devices, storage devices, etc., these devices may be herein referred to hereinafter as "heat-generating electronic components."

In Patent Document 1, a thermally-conductive resin molded body 1 is placed against a rear surface (surface with solder thereon) of an LED mounted substrate 6 via a heat dissipation sheet 7 that releases heat. Patent Document 2 discloses a structure where heat generated from a heat-generating electronic component 2 is released to a heat dissipation member 3 via a metal sheet 1-b and a thermally-conductive member 1-a. Patent Document 3 discloses a heat dissipation structure with which a skin layer 8 that has a three-dimensional shaped layer 2, is provided on a front surface of a thermally-conductive layer 1. Patent Document 4 discloses a heat dissipation structure 10 constituted of a heat-generating electronic component H, a thermally-conductive sheet 11 including expanded graphite as a material and disposed between the heat-generating electronic component H and a heat dissipation body 12, and a resin film 13 disposed between the thermally-conductive sheet 11 and the heat-generating electronic component H or between the thermally-conductive sheet 11 and the heat dissipation body 12. Patent Document 5 discloses an arrangement where a graphite sheet 20 is positioned on one surface of a thermoplastic resin 10 to reduce the temperature of an electronic device, such as a semiconductor, etc., and a circuit substrate 40 is disposed above the surface via an insulating sheet 30 to diffuse the heat of a heat-generating electronic component 50 mounted on the circuit substrate.

Although as described above, Patent Documents 1 to 5 disclose thermal conduction technologies using molded heat dissipation members, such as heat dissipation sheets, etc., when a molded heat dissipation member is used, a molding die, etc., must be made anew each time a substrate is modified because the dimensions and shape of the heat dissipation member differ according to each substrate. Also, front surfaces of most heat-generating electronic components are not smooth and therefore the heat dissipation member cannot be placed in close contact with the heat-generating electronic component and a substantial contact area between the heat-generating electronic component and the heat dissipation member is reduced. Also, heat-generating electronic components of various sizes, large and small, are used on the circuit substrate and the heat dissipation member, such as a heat dissipation sheet, etc., cannot follow the fine irregularities.

As described above, the heat dissipation performance by heat dissipation members cannot function sufficiently and consequently, satisfactory temperature reduction is not obtained.

Further in recent years, heat generation is forcibly suppressed by monitoring a temperature inside the electronic terminal equipment and restricting the function of the heat-generating electronic component in the electronic terminal equipment by using a program when the temperature exceeds a threshold value. For example, heat generation is suppressed by halting the executing program temporarily, delaying startup of the program, stopping a moving image temporarily, disconnecting a line, shutting down a camera forcibly, etc.

Prior Art Documents

Patent Documents

Patent Document 1: Japanese Patent Application Publication No. 2011-126262 A
Patent Document 2: Japanese Patent Application Publication No. 2002-305271 A

Patent Document 3: Japanese Patent Application Publication No. 2011-165699 A
Patent Document 4: Japanese Patent Application Publication No. 2008-153704 A
Patent Document 5: Japanese Patent Application Publication No. 2006-319134 A

Summary of Invention

Problems to be solved by the Invention

When the function of the heat-generating electronic component is restricted by the program control, the surface temperature of the electronic terminal equipment may be reduced thereafter, but smooth usability is obstructed because a certain function may be restricted as mentioned above.

Users demand higher performance and higher specifications in electronic terminal equipments and restriction of functions by the program control deviates from user's demands. It is thus desired to avoid function restriction by program control as much as possible or, even if function is restricted, delay of starting of the function restriction is possibly demanded.

Presently, for heat dissipation of such electronic terminal equipments, besides the program control described above, ways that are more efficient than before are demanded in heat-generating electronic components.

An object of the present invention is to provide an electronic terminal equipment in which compact and thin form is required, wherein (1) heat from a heat-generating electronic component is released efficiently without modification of design of a substrate, (2) a surface of the electronic terminal equipment is prevented from becoming to a high temperature locally (to prevent a heat spot) and (3) temperature is reduced in the heat-generating electronic component. An object of the present invention is to provide a method for assembling the above-mentioned electronic terminal equipment.

Means to Solve the Problem

In view of the above problems, the present invention has been completed by using, for heat dissipation, an electromagnetic shield member attached in proximity to a heat-generating electronic component that is mounted on a substrate for the electronic terminal equipment (hereinafter referred to simply as "electronic substrate"), so as to cover the heat-generating electronic component from at least an upper surface thereof.

An electronic terminal equipment according to the present invention includes (a) an electronic substrate mounting, on at least one surface thereof, a heat-generating electronic component and an electromagnetic shield member attached in proximity to the heat-generating electronic component so as to cover the heat-generating electronic component above at least an upper surface thereof, the electronic substrate being filled with a cured product of a thermally-conductive curable or thermosetting liquid resin between the electromagnetic shield member and the electronic substrate so that the resin is in contact with the heat-generating electronic component when cured, and (b) a highly thermally-conductive resin film disposed in contact with an upper surface of the electromagnetic shield member or facing the upper surface, the resin film diffusing heat drawn up through the thermally-conductive curable liquid resin.

The highly thermally-conductive resin film may be a graphite film having anisotropy in thermal conductivity.

The thermally-conductive curable liquid resin may be a thermally-conductive curable liquid resin that is cured by moisture or heat.

The electromagnetic shield member may have a shape that surrounds a periphery of the heat-generating electronic component with walls or the electromagnetic shield member may be a plate covering an upper surface of the heat-generating electronic component.

The heat-generating electronic component includes at least one of a computing device, a communication control device, and a storage device.

Preferably, the thermally-conductive curable liquid resin may be a resin constituted of a curable acrylic resin and/or curable polypropylene oxide based resin and a thermally-conductive filler. Preferably, the thermally-conductive curable liquid resin may have a thermal conductivity of not less than 0.5 W/mK.

The highly thermally-conductive resin film has a thermal conductivity in a direction along its surface of not less than 300 W/mK, preferably not less than 600 W/mK, and more preferably not less than 1000 W/mK, and has a thickness of not more than 350 em, preferably not more than 100 em, and even more preferably not more than 50 em.

A method for assembling an electronic terminal equipment according to the present invention is a method of, (a) filling a thermally-conductive curable liquid resin between an electromagnetic shield member and an electronic substrate and cured so as to contact a heat-generating electronic component, the electronic substrate having, on at least one surface thereof, the heat-generating electronic component and the electromagnetic shield member attached in proximity to the heat-generating electronic component so as to cover the heat-generating electronic component above at least an upper surface thereof, and (b) assembling the electronic terminal equipment by arranging a highly thermally-conductive resin film in contact with or facing an upper surface of the electromagnetic shield member, in order to diffuse heat drawn up through the thermally-conductive curable liquid resin.

With the present invention, by filling the thermally-conductive curable liquid resin between the electromagnetic shield member and the electronic substrate so as to contact the heat-generating electronic component, heat generated from the heat-generating electronic component can be released via the thermally-conductive curable liquid resin to reduce the temperature of the heat-generating electronic component. In addition, the heat drawn up through the thermally-conductive curable liquid resin can be diffused by the highly thermally-conductive resin film and consequently generation of heat spots can be reduced. The reduction of heat spots may prevent users of the electronic terminal equipment from thermal burn.

Also with the present invention, the temperature of the heat-generating electronic component is reduced and therefore duration till such a situation that "the function of a program is restricted due to temperature rise in the electronic terminal equipment" can be extended.

Further with the present invention, not only is the temperature of a front surface of the electronic terminal equipment reduced but the temperature of the heat-generating electronic component itself is reduced so as to suppress "degradation and damage of circuit components due to accumulation of heat in an interior of the electronic terminal equipment."

Furthermore, the thermally-conductive curable liquid resin of the present invention is a liquid substance prior to curing and therefore follows irregularities of the heat-generating electronic component of any of various sizes, large and small, and is thus brought in highly close contact with the heat-generating electronic component after the resin is cured. Thus, thermal contact resistance with respect to the heat-generating electronic component is low and the heat generated from the heat-generating electronic component can be released with high efficiency.

The above and yet other advantages, features, and effects of the present invention will become apparent from the following detailed description of the preferred embodiments with reference to the attached drawings.

Brief Description of Drawings

FIG. 1 is a schematic plan view of an internal substrate of an electronic terminal equipment according to a preferred embodiment of the present invention. A state where a rear surface cover of the electronic terminal equipment is removed is shown.

FIG. 2 is a schematic sectional side view of an electronic terminal equipment with which heat dissipation is managed using a highly thermally-conductive resin film.

FIG. 3 is a schematic sectional side view of an electronic terminal equipment with which heat dissipation is conceived using a thermally-conductive curable liquid resin.

FIG. 4 is a schematic sectional side view of an electronic terminal equipment according to a preferred embodiment of the present invention with which heat dissipation is managed using a thermally-conductive curable liquid resin and a highly thermally-conductive resin film.

FIG. 5 is a schematic sectional side view of an electronic terminal equipment according to a preferred embodiment of the present invention with which heat dissipation is conceived using a thermally-conductive curable liquid resin and a highly thermally-conductive resin film.

FIG. 6 is a schematic sectional side view of an electronic terminal equipment according to a preferred embodiment of the present invention with which heat dissipation is managed using a thermally-conductive curable liquid resin and a highly thermally-conductive resin film.

FIG. 7 is a schematic sectional side view of an electronic terminal equipment according to a preferred embodiment of the present invention with which a heat dissipation is managed using a thermally-conductive curable liquid resin and a highly thermally-conductive resin film.

FIG. 8 is a schematic sectional side view of an electronic terminal equipment according to a preferred embodiment of the present invention with which a heat dissipation is managed using a thermally-conductive curable liquid resin and a highly thermally-conductive resin film.

FIG. 9 is a schematic figure of an apparatus configured to perform heat dissipation measurement of electronic terminal equipments used in examples of the present invention.

Preferred Embodiments

<Electronic terminal equipment>

An electronic terminal equipment according to the present invention is not further restricted in particular as long as it is a equipment having a heat-generating electronic component on a substrate. The electronic terminal equipment may, for example, be used in such applications as electronic equipments, precision equipments, automobile components, etc. In particular among electronic terminal equipments, the present invention is favorable for portable mobile terminals, such as cellular phones, smart phones, tablets, laptop computers, digital cameras, portable game terminals, etc.

As specific examples of the electronic terminal equipment, (1) computer equipments, such as servers, server computers, and desktop computers, etc., (2) portable equipments, such as game equipments, laptop computers, electronic dictionaries, PDAs, cellular phones, smart phones, tablet terminals, portable music players, etc., (3) display devices, such as liquid crystal displays, plasma displays, surface-conduction electron-emitter displays (SEDs), LEDs, organic EL displays, inorganic EL displays, liquid crystal projectors, watches, etc., (4) image forming apparatuses, such as inkjet printers (ink heads), electro photographic apparatuses (developing apparatuses, fixing apparatuses, heat rollers, heat belts), etc., (5) semiconductor-related components, such as semiconductor devices, semiconductor packages, semiconductor sealing cases, semiconductor die-bonding portions, CPUs, memories, power transistors, power transistor cases, etc., (6) wiring substrates, such as rigid wiring boards, flexible wiring boards, ceramic wiring boards, build-up wiring boards, multilayer substrates, etc. (the aforementioned wiring boards also include printed wiring boards, etc.), (7) manufacturing apparatuses, such as vacuum processing apparatuses, semiconductor manufacturing apparatuses, display manufacturing apparatuses, etc., (8) heat insulating apparatuses, such as heat insulating materials, vacuum heat insulating materials, radiant heat insulating materials, etc., (9) data storage devices, such as DVDs (optical pickups, laser beam generators, laser receiving apparatuses), hard disk drives, etc., (10) image recording apparatuses, such as cameras, video cameras, digital cameras, digital video cameras, microscopes, CCDs, etc., and (11) battery apparatuses, such as charging apparatuses, lithium ion batteries, fuel cells, solar cells, etc., can be cited.

<Heat-generating electronic component>

The heat-generating electronic component is not further restricted in particular as long as it is an electronic component that generates heat during operation of the electronic terminal equipment. As examples, semiconductor devices, such as transistors, integrated circuits (ICs), CPUs, diodes, LEDs, etc., and electronic components, such as electron tubes, electric motors, resistors, condensers (capacitors), coils, relays, piezoelectric devices, oscillators, speakers, heaters, various batteries, various chip components, etc., can be cited.

With regard to heat generation density (the heat generation density is the thermal energy emitted from a unit area in a unit time), the heat-generating electronic component is preferably that of not less than 0.5 $W/cm^2$ and preferably that of not more than 1000 $W/cm^2$. A heat-generating electronic component with a heat generation density of not less than 0.5 $W/cm^2$ generates heat and becomes high in temperature during operation and the performance of the component tends to degrade readily.

When the performance of a component degrades due to its own heat, the component becomes unable to perform as anticipated at an ordinary current value then problems, such as decreased processing speed, temporary stoppage of processing, etc., are encountered. Consequently, freezing or decrease of processing speed of the product terminal equipment itself is caused. Further, "thermal runaway" occurs in which current more than a threshold value flows into the component in order to achieve the desired performance and the component generates much heat, and an unexpected cycle is entered so that the component degrades down.

Not only does the function of the product degrade but there is also the problem that the temperature of the product itself also rises due to heat generation by a component, thereby increasing the risk of low-temperature burns for users.

There may be mounted just a single such heat-generating electronic component on the substrate or a plurality thereof may be mounted on the substrate. Also, with regard to a heat-generating electronic component inside an electromagnetic shield member, there may be just one such component on the substrate or a plurality thereof may be mounted on the substrate.

In case that a plurality of electronic components is mounted on the substrate, the electronic components do not need to be matched in height from the substrate. By disposing an uncured thermally-conductive curable or thermosetting liquid resin and thereafter curing it in accordance with the present invention, close contact can be realized to enable efficient heat dissipation of the heat generated from the electronic components even if the heights of the electronic components are not matched.

<Electromagnetic shield member>

The electromagnetic shield member refers to a member that exhibits electromagnetic shield performance by reflecting, conducting, or absorbing electromagnetic waves. The material of the electromagnetic shield member is not restricted in particular as long as it is a material that exhibits electromagnetic shield performance by reflecting, conducting, or absorbing electromagnetic waves. For example, a metal material, a plastic material, or any of various magnetic materials, etc., may be used and a metal material may be used preferably.

As the metal material, a metal material constituted of just a metal element is favorable. As examples of a simple metal element in the metal material, an device of Group 1 of the periodic table, such as lithium, sodium, potassium, rubidium, and cesium; an device of Group 2 of the periodic table, such as magnesium, calcium, strontium, barium, etc.; an device of Group 3 of the periodic table, such as scandium, yttrium, a lanthanide device (lanthanum, cerium, etc.), an actinide device (actinium, etc.), etc.; an device of Group 4 of the periodic table, such as titanium, zirconium, hafnium, etc.; an device of Group 5 of the periodic table, such as vanadium, niobium, tantalum, etc.; an device of Group 6 of the periodic table, such as chromium, molybdenum, tungsten, etc.; an device of Group 7 of the periodic table, such as manganese, technetium, rhenium, etc.; an device of Group 8 of the periodic table, such as iron, ruthenium, osmium, etc.; an device of Group 9 of the periodic table, such as cobalt, rhodium, iridium, etc.; an device of Group 10 of the periodic table, such as nickel, palladium, platinum, etc.; an device of Group 11 of the periodic table, such as copper, silver, gold, etc.; an device of Group 12 of the periodic table, such as zinc, cadmium, mercury, etc.; an device of Group 13 of the periodic table, such as aluminum, gallium, indium, thallium, etc.; an device of Group 14 of the periodic table, such as tin, lead, etc.; an device of Group 15 of the periodic table, such as antimony, bismuth, etc., can be cited. On the other hand, as examples of an alloy, stainless steel, copper-nickel alloy, brass, nickel-chromium alloy, iron-nickel alloy, zinc-nickel alloy, gold-copper alloy, tin-lead alloy, silver-tin-lead alloy, zinc-nickel alloy, gold-copper alloy, tin-lead alloy, silver-tin-lead alloy, nickel-chromium-tin alloy, copper-manganese-nickel alloy, nickel-manganese-iron alloy, etc., can be cited.

Also, with regard to metal based compounds containing a non-metal element together with a metal element, there is no further restriction in particular as long as it is a metal based compound containing any of the metal elements and alloys given as examples above that exhibits electromagnetic shield performance. As examples, metal sulfides, such as copper sulfide, etc.; metal oxides and complex metal oxides, such as iron oxide, titanium oxide, tin oxide, indium oxide, cadmium tin oxide, etc., can be cited.

Also as a specific metal material, gold, silver, aluminum, iron, copper, nickel, stainless steel, or copper-nickel alloy may be used favorably.

As examples of a plastic material, conductive plastics, such as polyacetylene, polypyrrole, polyacene, polyphenylene, polyaniline, polythiophene, etc., can be cited. Further, a carbon material, such as graphite, etc., can be cited.

As examples of a magnetic material, soft magnetic powder, any of various ferrites, zinc oxide whiskers, etc., can be cited. As the magnetic material, a ferromagnetic substance that exhibits ferromagnetism or ferrimagnetism is favorable. As specific examples of the magnetic material, high-permeability ferrite, pure iron, silicon-atom-containing iron, nickel-iron based alloy, iron-cobalt based alloy, high-permeability amorphous metal material, iron-aluminum-silicon alloy, iron-aluminum-silicon-nickel alloy, iron-chromium-cobalt alloy, etc., can be cited.

The electromagnetic shield member is attached in proximity to the heat-generating electronic component so as to cover the heat-generating electronic component at least from its upper surface. Further, the electromagnetic shield member may surround a periphery of the heat-generating electronic component with side walls.

The electromagnetic shield member may have a hole or gap opened on an upper portion or a side wall to an extent where its electromagnetic shield performance is not compromised. Also, the electromagnetic shield member is not required to be an integral object and may be of a type with which the upper portion can be separated like a lid or a type that can be separated into two or more pieces.

It is preferable for the electromagnetic shield member to have a higher thermal conductivity because the temperature distribution will then be more uniform and the heat generated by the electronic component inside the electromagnetic shield member can be transmitted more effectively to the exterior. For improved heat dissipation property, the thermal conductivity of the electromagnetic shield member is preferably not less than 1 W/mK, more preferably not less than 3 W/mK, even more preferably not less than 5 W/mK, and most preferably not less than 10 W/mK. The thermal conductivity of the electromagnetic shield member is preferably not more than 10000 W/mK.

<Thermally-conductive curable liquid resin>

As the thermally-conductive curable liquid resin, a resin composition containing at least a curable liquid resin and a thermally-conductive filler is used. In addition to the above, a curing catalyst for curing the curable liquid resin, a heat aging preventing agent, a plasticizer, an extender, a thixotropy imparting agent, a storage stabilizer, a dehydrating agent, a coupling agent, an ultraviolet absorber, a flame retardant, an electromagnetic wave absorber, a filler, a solvent, etc., may be added as necessary.

<The curable liquid resin>

As the curable liquid resin, a liquid resin having a reactive group within the molecule and having a curing property is preferable. As specific examples of the curable liquid resin, curable acrylic resins and curable methacrylic resins, curable polyether based resins as represented by curable polypropylene oxide based resins, curable polyolefin based resins as represented by curable polyisobutylene based resins, etc., can be cited. As the reactive group, any of various reactive functional groups, such as an epoxy group, hydrolyzable silyl group, vinyl group, acryloyl group, SiH group, urethane group, carbodiimide group, a combination of a carboxylic anhydride group and an amino group, etc., may be used.

If curing occurs through a combination of two types of reactive groups or through a reaction of a reactive group and a curing catalyst, the cured product can be obtained by preparing a two-liquid type composition and mixing the two liquids in the process of coating onto the substrate or the heat-generating electronic component.

Or, in a case of a curable resin having a hydrolyzable silyl group, a one-liquid type room temperature curable composition may be used because curing can be achieved through reaction with moisture in the air. In a case of a combination of a vinyl group, the SiH group, and a Pt catalyst or in a case of a combination of a radical initiator and an acryloyl group, etc., a one-liquid type curable composition or a two-liquid type curable composition may be arranged and curing may thereafter be achieved by heating to a crosslinking temperature or by applying crosslinking energy in the form of ultraviolet rays, electron beam, etc.

If it is easy to heat the entire heat dissipation structure to some degree, it is preferable to use a heat curing type composition in general and if it is difficult to heat the heat dissipation structure, a two-liquid type curable composition or a moisture curing type composition is preferable, though the present invention is not restricted to these.

Among curable liquid resins, the use of a curable acrylic resin or a curable polypropylene oxide based resin is preferable in that they are unlikely to cause the problem of internal contamination of the electronic equipment due to low molecular weight siloxane and excellent in heat resistance, etc. Any of various known reactive acrylic resins may be used as the curable acrylic resin. Among these, the use of an acrylic oligomer having a reactive group at a molecular terminal is preferable.

With regard to such curable acrylic resins, a combination of a curable acrylic resin, manufactured by living radical polymerization, especially, atom transfer radical polymerization, and a curing catalyst may be used most preferably. As an example of such a resin, "Kaneka XMAP" (trademark) supplied by Kaneka Corporation is known. Also, as the curable polypropylene oxide based resin, any of various known reactive polypropylene oxide resins may be used, and "Kaneka MS Polymer" (trademark) by Kaneka Corporation can be cited as an example. Such a curable liquid resin may be used alone or two or more types may be used in combination.

<Thermally-conductive filler>

As the thermally-conductive filler used in the thermally-conductive curable liquid resin and the thermally-conductive cured product, any of carbon compounds, such as graphite, diamond, etc.; metal oxides, such as aluminum oxide, magnesium oxide, beryllium oxide, titanium oxide, zirconium oxide, zinc oxide, etc.; metal nitrides, such as boron nitride, aluminum nitride, silicon nitride, etc.; metal carbides, such as boron carbide, aluminum carbide, silicon carbide, etc.; metal hydroxides, such as aluminum hydroxide, magnesium hydroxide, etc.; metal carbonates, such as magnesium carbonate, calcium carbonate, etc.; crystalline silica; organic polymer baked products, such as acrylonitrile based polymer baked products, furan resin baked products, cresol resin baked products, polyvinyl chloride baked products, baked products of sugar, baked products of charcoal, etc.; composite ferrite with Zn ferrite; Fe-Al-Si based ternary alloy; metal powders, etc., can be cited in that they are favorable from the various aspects of thermal conductivity, availability, insulating and filling properties, toxicity, and from the aspect of ability to impart electrical characteristics, such as electromagnetic wave absorbing property, etc.

In examples of the present invention, boron nitride and aluminum oxide were used.

Also, from the point of improving dispersibility with respect to resin, the thermally-conductive fillers are preferably those that are surface-treated with a silane coupling agent (vinylsilane, epoxysilane, (meth)acrylsilane, isocyanate silane, chlorosilane, aminosilane, etc.), a titanate coupling agent (alkoxytitanate, aminotitanate, etc.), a fatty acid (a saturated fatty acid, such as caproic acid, caprylic acid, capric acid, lauric acid, myristic acid, palmitic acid, stearic acid, behenic acid, etc., an unsaturated fatty acid, such as sorbic acid, elaidic acid, oleic acid, linoleic acid, linolenic acid, erucic acid, etc.) or a resin acid (abietic acid, pimaric acid, levopimaric acid, neoabietic acid, palustric acid, dehydroabietic acid, isopimaric acid, sandaracopimaric acid, communic acid, secodehydroabietic acid, dihydroabietic acid, etc.), etc.

With regard to the usage amount of such a thermally-conductive filler, it is preferable for a volume percentage (%) of the thermally-conductive filler to be not less than 25 volume % of the entire composition from the point that the thermal conductivity of the thermally-conductive material obtained from the resin composition of the present invention can be made high. If the volume percentage is less than 25 volume %, the thermal conductivity tends to be insufficient. If an even higher thermal conductivity is desired, the usage amount of the thermally-conductive filler is set more preferably to not less than 30 volume % of the entire composition, even more preferably to not less than 40 volume %, and especially preferably to not less than 50 volume %. Also, it is preferable for the volume percentage (%) of the thermally-conductive filler to be not more than 90 volume % of the entire composition. If the volume percentage is greater than 90 volume %, the viscosity of the thermally-conductive curable liquid resin may be too high.

Here, the volume percentage (%) of the thermally-conductive filler is calculated from respective weight ratio and specific gravity of the resin component and weight ratio and specific gravity of the thermally-conductive filler, and is determined by the following formula (1). In the following formula (1), the thermally-conductive filler prior to curing is indicated simply as "filler."

Filler volume percentage (volume %) = (Filler weight ratio/filler specific gravity)/[(resin component weight ratio/resin component specific gravity) + (Filler weight ratio/filler specific gravity)] $\times$ 100 ...(1)

Here, the resin component refers to the total of components excluding the thermally-conductive filler.

As a method for increasing a filling ratio of the thermally-conductive filler with respect to the resin, it is favorable to use two or more types of thermally-conductive fillers that are different in particle diameters in combination. In that case, it is preferable for the larger particle diameter to be in the excess of 10 $\mu$m and the smaller particle diameter to be not more than 10 $\mu$m. Also as these thermally-conductive fillers, not just thermally-conductive fillers of the same material but thermally-conductive fillers of two or more different materials may also be used in combination.

Also, by combining a filler of small maximum particle diameter, a thin film property can be secured. By using a filler preferably with a maximum particle diameter of not more than 200 $\mu$m, more preferably with a maximum particle diameter of not more than 100 $\mu$m, and even more preferably with a maximum particle diameter of not more than 50 $\mu$m, the thermally-conductive curable resin can be made to flow even into a fine gap.

<Cured product of thermally-conductive curable liquid resin>

The cured product of the thermally-conductive curable liquid resin of the present invention is a product of the thermally-conductive curable liquid resin that are filled and cured between the electromagnetic shield member and the electronic substrate so as to contact the heat-generating electronic component.

The cured product of the thermally-conductive curable liquid resin (also referred to as "thermally-conductive cured product") preferably has a thermal conductivity of not less than 0.5 W/mK and a tensile modulus of not more than 50 MPa.

The thermally-conductive resin is preferably that which is a liquid initially and is cured by moisture or heat. The thermal conductivity of the thermally-conductive cured product is preferably not less than 0.5 W/mK, more preferably not less than 0.8 W/mK, and even more preferably not less than 1.0 W/mK.

Also, the thermally-conductive cured product is preferably a rubber elastic body with a tensile modulus of not more than 50 MPa and more preferably not more than 40 MPa. A thermally-conductive resin that is a rubber elastic body with a tensile modulus of not more than 50 MPa refers to a rubber elastic body with a tensile modulus of not more than 50 MPa when the tensile modulus is measured by the method of JIS K 6251.

As examples of a thermally-conductive resin that is a rubber elastic body with a tensile modulus of not more than 50 MPa, curable acrylic resins and curable methacrylic resins, curable polyether based resins as represented by curable polypropylene oxide based resins, curable polyolefin based resins as represented by curable polyisobutylene based resins, etc., which shall be described below, can be cited.

<Highly thermally-conductive resin film>

The highly thermally-conductive resin film of the present invention is a film arranged to diffuse heat drawn up through the thermally-conductive curable liquid resin and is disposed in contact with an upper surface of the electromagnetic shield member or facing the upper surface.

The highly thermally-conductive resin film has a characteristic of being high in thermal conductivity in a surface direction as compared with that in a thickness direction. The thermal conductivity of the highly thermally-conductive resin film in the surface direction is not less than 50 W/mK, preferably not less than 100 W/mK, more preferably not less than 200 W/mK, and most preferably not less than 500 W/mK. On the other hand, it is satisfactory for the thermal conductivity of the highly thermally-conductive resin film in the thickness direction to be not more than 30 W/mK, preferably not more than 20 W/mK, and more preferably not more than 10 W/mK. If the thermal conductivity of the highly thermally-conductive resin film in the thickness direction is greater than 30 W/mK, the heat generated from the heat-generating electronic component is transmitted directly to a heat dissipation body before it is diffused. On the other hand, if the thermal conductivity of the highly thermally-conductive resin film in the thickness direction is not more than 30 W/mK, the heat transmitted from the heat-generating electronic component is less transmitted in the thickness direction and the proportion released in the surface direction becomes larger, that is advantageous.

As the highly thermally-conductive resin film, one including a graphite film is preferably used, however the present invention is not restricted thereto, for example an artificial graphite film, natural graphite film, copper foil, aluminum foil, silver foil, thermally-conductive Kapton (trademark) film, indium sheet, etc., may also be used.

<Protective film to be adhered to graphite film>

Graphite film may fall off powder in some cases and that may cause contamination of the interior of the equipment. Also, a graphite film exhibits electrical conductivity and may cause short-circuiting of the electronic substrate. Due to such reasons, a graphite film is preferably used with a protective film adhered.

As the protective film, a film of polyimide, polyethylene terephthalate, polyethylene, polypropylene, or polyester, etc. is preferable with an acrylic-based, silicone-based, epoxy-based, or polyimide-based tacky material or adhesive formed on one surface thereof. The film may be a polyester-based or other hot melt type (thermoplastic) film. Also, a tape with a high thermal radiation is preferable in that when it is adhered in the non-contact state, the amount of heat transmission increases. A resin tape is low in thermal conductivity and therefore a thin resin tape is preferable. On the surface of the highly thermally-conductive resin film that is in contact with a thermally-conductive material layer, the protective film does not have to be used because the possibility of falling-off of powder and short-circuiting due to a graphite film is low at that surface. It is more preferable not to use a protective film because the thermal conductive property is then improved, but removal of the protective film at a portion during manufacture of the highly thermally-conductive resin film may cause increase of production cost.

<Adhesive layer to be adhered to graphite film>

The highly thermally-conductive resin film that includes the graphite film is preferably used upon adhesion to the heat dissipation body by an adhesive layer of a tacky material or adhesive, etc. The material of the tacky material or adhesive used as the adhesive layer in the invention may be an acrylic-based, silicone-based, epoxy-based, or polyimide-based resin. Such a tacky material and adhesive are poor in thermal conductivity and therefore the adhesive layer is basically the thinner the better.

<Method for manufacturing graphite film>

A first method for manufacturing the graphite film that is favorably used in the present invention is to produce a graphite film with which a graphite powder is compacted to a sheet. For the graphite powder to be formed to a film, the powder must be in the form of flakes or scales. A most general method for manufacturing graphite powder of such form is a method called the expansion (expanded graphite) method. With that method, graphite is immersed in an acid, such as sulfuric acid, etc., to prepare a graphite intercalation compound that is thereafter heat-treated and foamed to peel the graphite layers from each other. After peeling, the graphite powder is washed to remove the acid and obtain a thin-film graphite powder. The graphite powder obtained by such a method is further subject to mill roll forming to obtain graphite of film form. The graphite film obtained by such a method and prepared using expanded graphite is high in flexibility and anisotropy in thermal conductive property, that is, has a high thermal conductive property in the surface direction of the film and can thus be used favorably for the purpose of the present invention.

A second method for manufacturing the graphite film that is favorably used in the present invention is that by which a film graphite is prepared by heat treatment of at least one type of resin selected from the group consisting of polyimide resins, polyparaphenylenevinylene resins, and polyoxadiazole resins. The resin that is most generally used in that method is a polyimide resin. In the graphitization of polyimide or other resin film, a graphite film is obtained by carbonizing the resin film that is the starting substance by keeping it in nitrogen gas in a temperature region of ordinarily approximately 1000°C for a time of approximately 30 minutes and thereafter performing the graphitization in argon or other inert gas at a temperature of at least not less than 2400°C, preferably not less than 2700°C, and more preferably not less than 2800°C.

Examples

Although the present invention shall now be described in further detail based on examples, the present invention is not restricted by these examples.

(Resin Synthesis Example 1)

Under a nitrogen atmosphere, CuBr (1.09 kg), acetonitrile (11.4 kg), butyl acrylate (26.0 kg), and diethyl 2,5-dibromoadipate (2.28 kg) were added to a 250 L reactor and stirred for approximately 30 minutes at 70 to 80°C. Pentamethyldiethylenetriamine was added to the above to start a reaction. From 30 minutes after the start of reaction, butyl acrylate (104 kg) was added continuously over a period of 2 hours. Pentamethyldiethylenetriamine was added as suitable during the reaction to keep the internal temperature at 70°C to 90°C. The total amount of pentamethyldiethylenetriamine used up to this point was 220 g. After 4 hours from the start of reaction, volatile matter was removed by heating and stirring at 80°C under reduced pressure. Acetonitrile (45.7 kg), 1,7-octadiene (14.0 kg), and pentamethyldiethylenetriamine (439 g) were then added thereto and stirring was continued for 8 hours. The mixture was heated and stirred at 80°C under reduced pressure to remove volatile matter.

After adding toluene to the concentrate and dissolving the polymer, diatomaceous earth as a filter aid and aluminum silicate and hydrotalcite as adsorbents were added, and heating and stirring were performed at an internal temperature of 100°C under an oxygen-nitrogen mixed gas atmosphere (oxygen concentration: 6%). The solids in the mixed liquid were removed by filtration and volatile matter was removed by heating and stirring the filtrate at an internal temperature of 100°C under reduced pressure.

Further, aluminum silicate and hydrotalcite as adsorbents and a thermal degradation preventing agent were added to the concentrate and then heating and stirring under reduced pressure were performed (average temperature: 175°C; decompression degree: not more than 10 Torr).

Further, aluminum silicate and hydrotalcite were added as adsorbents, an antioxidant was added, and then heating and stirring were performed at an internal temperature of 150°C under an oxygen-nitrogen mixed gas atmosphere (oxygen concentration: 6%).

After adding toluene to the concentrate and dissolving the polymer, the solids in the mixed liquid were removed by filtration and volatile matter was removed by heating and stirring the filtrate under reduced pressure to obtain a polymer having alkenyl groups.

The polymer having alkenyl groups, dimethoxymethylsilane (2.0 molar equivalents per alkenyl group), methyl orthoformate (1.0 molar equivalent per alkenyl group), and a platinum catalyst [xylene solution of bis(1,3-divinyl-1,1,3,3-tetramethyldisiloxane)-platinum complex catalyst; hereinafter referred to as the "platinum catalyst"] (10 mg as platinum per 1 kg of polymer) were mixed, and heating and stirring were performed at 100°C under a nitrogen atmosphere. Upon confirming the elimination of the alkenyl groups, the reaction mixture was concentrated and a poly(n-butyl acrylate) resin having a dimethoxysilyl group at the terminals (I-1) was obtained. The number average molecular weight of the resin obtained was approximately 26000 and the molecular weight distribution was 1.3. The average number of silyl groups introduced per molecule of resin was determined to be approximately 1.8 by $^1$H NMR analysis.

(Resin Synthesis Example 2)

Using polyoxypropylene diol with a number average molecular weight of approximately 2,000 as an initiator, propylene oxide was polymerized with a zinc hexacyanocobaltate-glyme complex catalyst to obtain polypropylene oxide with a number average molecular weight of 25,500 (polystyrene equivalent value measured using HLC-8120 GPC, made by Tosoh Corporation, as the liquid feeding system, using TSK-GEL H Type, made by Tosoh Corporation, as the column, and using THF as the solvent). Subsequently, NaOMe methanol solution of 1.2 times equivalent of the hydroxyl groups of the hydroxyl-group-terminated polypropylene oxide was added, the methanol was distilled off, and allyl chloride was added to convert the hydroxyl groups at the terminal to allyl groups. The unreacted allyl chloride was removed by reduced pressure devolatilization. With respect to 100 parts by weight of the obtained unrefined allyl-group-terminated polypropylene oxide, 300 parts by weight of n-hexane and 300 parts by weight of water were mixed and stirred, and thereafter, the water was removed by centrifugation, 300 parts by weight of water were further mixed and stirred with the hexane solution obtained, and after removing the water again by centrifugation, the hexane was removed by reduced pressure devolatilization. A bifunctional polypropylene oxide terminated with allyl groups and having a number average molecular weight of approximately 25,500 was thereby obtained.

With respect to 100 parts by weight of the allyl-terminated polypropylene oxide obtained, 150 ppm of an isopropanol solution of a platinum vinylsiloxane complex with a platinum content of 3 wt% were added as a catalyst and reaction with 0.95 parts by weight of trimethoxysilane at 90°C was performed for 5 hours to obtain a trimethoxysilyl-group-terminated polyoxypropylene based polymer (I-2). The average number of terminal trimethoxysilyl groups per molecule was determined, by $^1$H-NMR in the same manner as the above, to be approximately 1.3.

(Thermally-conductive curable liquid resin)

After sufficiently stirring and kneading 90 parts by weight of the resin (I-1) obtained in Synthesis Example 1, 10 parts by weight of the resin (I-2) obtained in Synthesis Example 2, 100 parts by weight of a plasticizer (Monocizer W-7010; made by DIC Corporation), 1 part by weight of an antioxidant (Irganox 1010), and the thermally-conductive filler manually, vacuum was drawn to dehydrate while heating and kneading using a 5 L butterfly mixer. After completion of dehydration, cooling was performed, 2 parts by weight of a dehydrating agent (A171) and 4 parts by weight each of curing catalysts (tin neodecanoate and neodecanoic acid) were mixed to obtain a thermally-conductive curable liquid resin.

(Measurement of thermal conductivity of thermally-conductive curable liquid resin)

The thermally-conductive curable liquid resin was wrapped in Saran Wrap (Saran Wrap is a registered trademark) and a hot disk method thermal conductivity measurement apparatus TPA-501 (made by Kyoto Electronics Manufacturing Co., Ltd.) was used to measure the thermal conductivity by a method of sandwiching a 4φ size sensor with two samples.

(Measurement of tensile modulus of cured product of thermally-conductive curable liquid resin)

The thermally-conductive curable liquid resin was cured to prepare a mini dumbbell and the tensile modulus was measured with reference to JIS K 6251.

(Highly thermally-conductive resin film)

Graphite films were used as highly thermally-conductive resin films. Graphite films with thicknesses of 40 μm and 25 μm were prepared.

(Measurement of thermal diffusivity of highly thermally-conductive resin film)

Using a thermal diffusivity measuring apparatus based on a laser-heating AC method (LaserPit, made by Ulvac-Riko, Inc.) and upon cutting each graphite film into sample shapes of 4 mm × 40 mm, the thermal diffusivity in the surface direction was measured at 10 Hz under an atmosphere of 20°C.
LFA-502, made by Kyoto Electronics Manufacturing Co., Ltd. was used to measure the thermal diffusivity in the thickness direction of each graphite film by a laser flash method. Each graphite film was cut to a diameter of 10 mm and after blackening both surfaces of the film, the thermal diffusivity in the thickness direction was measured at room temperature by the laser flash method.
Calculation may also be performed by calculating the thermal capacity of the graphite film from a comparison with the reference standard substance Mo of known thermal capacity and using this together with the density, which is measured separately, in the following formula (2).

$$\lambda = \alpha \times d \times Cp \quad \ldots (2)$$

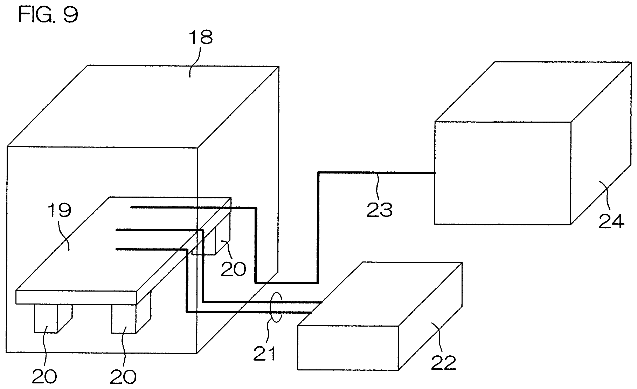

In formula (2), $\lambda$ expresses the thermal conductivity, $\alpha$ expresses the thermal diffusivity, d expresses the density, and Cp expresses the specific heat capacity, respectively.
(Measurement of heat dissipation temperatures of heat-generating electronic component, substrate, and electromagnetic shield member)
A heat dissipation experiment was performed using a cellular phone (smart phone NC-06C) 19, made by NEC, as an electronic terminal equipment as shown in FIG. 9.
To block influences from the external environment, the smart phone 19 was surrounded by a 30x30x30 cm heat insulating box 18. Any material may be used as the material of the heat insulating box 18 as long as it can block the convection of external air, and the material may, for example, be foamed urethane, foamed polystyrene, cork, or even a blackout curtain. A heat insulating material of foamed urethane was used in the present experiment.
To prevent temperature change due to convection of air within the laboratory during measurement, four columns 20 of 5 cm height were installed inside the heat insulating box 18 as shown in FIG. 9 and the smart phone 19 was set thereon.
Temperatures of heat-generating electronic components and a substrate inside the smart phone 19 and a temperature of a front surface of the smart phone 19 were measured using Teflon (Teflon is a registered trademark) coated ultrathin double-wire thermocouples TT-D-40-SLE (made by Omega Engineering Inc.) 21.

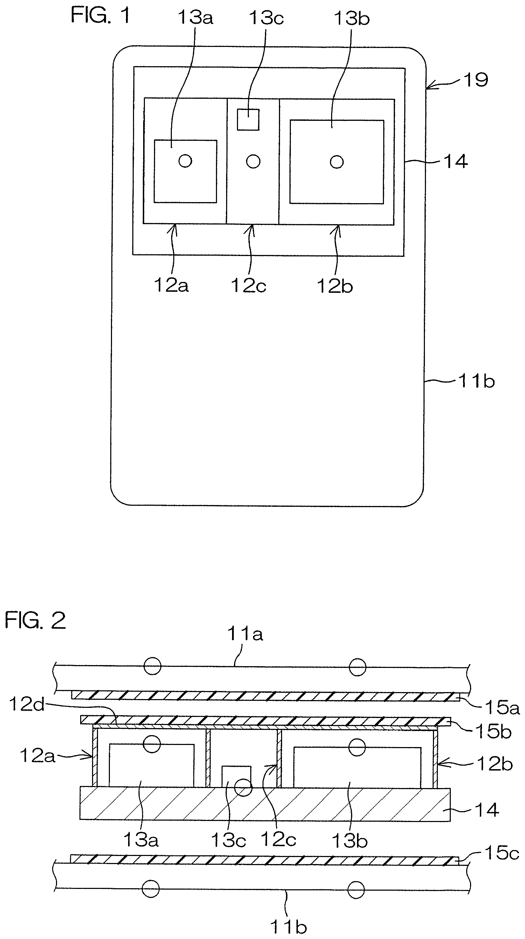

FIG. 1 is a schematic plan view showing a state where a portion 11a of a housing of the smart phone 19 is removed to expose an internal substrate 14. The substrate 14 has heat-generating electronic components 13a and 13b, an electronic component 13c that is not a heat-generating electronic component, electromagnetic shield members 12a and 12b attached in proximity to the heat-generating electronic components 13a and 13b so as to cover upper surfaces and peripheries of the heat-generating electronic components 13a and 13b, and an electromagnetic shield member 12c attached so as to cover an upper surface and a periphery of the electronic component 13c that is not a heat-generating electronic component. Although one each of the heat-generating electronic components 13a and 13b and the electronic component 13c are drawn, the actual number is not restricted to one. Upper surface 12d of the electromagnetic shield members 12a, 12b, and 12c is not drawn in FIG. 1.

Temperature measurement points were set at a total of seven locations indicated by "o" in FIG. 1 to FIG. 8, and, as shown in FIG. 9, the thermocouples 21 adhered to these locations were exposed from a gap in the insulating box 18, the exposed thermocouples 21 were connected to a data logger 22, and temperature changes with time were recorded with the data logger 22.

To ensure a simulated communication state, a cellular antenna 23 of the smart phone 19 was exposed from a gap in the insulating box 18 and the exposed cellular antenna 23 was connected to Anritsu Corporation's radio communication analyzer (item: 8820C (LTE/wCDMA:XI) MT8820C-Op 001/008) 24 to put the smart phone 19 in the simulated communication state (10 dBm).

Also, the smart phone 19 was set to an HD moving image photography mode.

(Examples 1 to 5)

The portion 11a of the casing of the smart phone 19 was removed to expose the substrate 14, the upper surfaces 12d of the electromagnetic shield members 12a and 12b on the substrate were removed, filling and curing of a thermally-conductive curable liquid resin 16 were performed, the electromagnetic shield member b was capped with the upper surfaces 12d, and a highly thermally-conductive resin film was disposed at an inner side of the casing 11a and/or the upper surfaces 12d of the electromagnetic shield members.

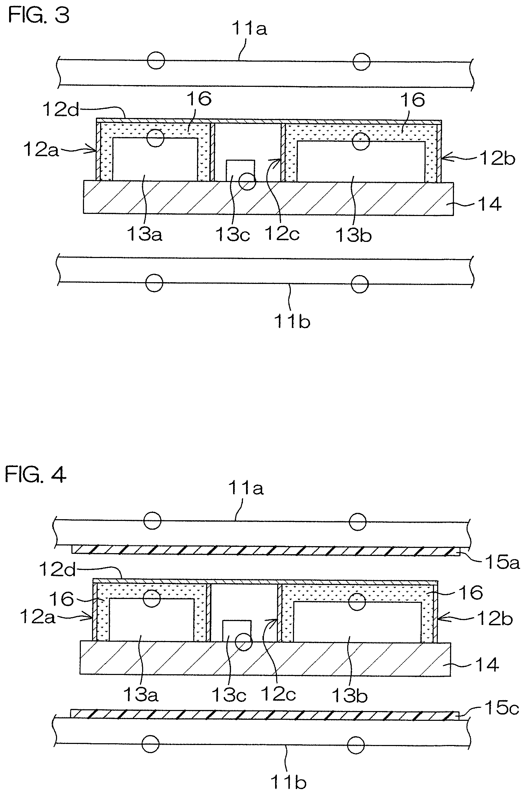

FIG. 4 is a sectional view where, the upper surfaces 12d of the electromagnetic shield members that surround the heat-generating electronic components 13a and 13b were removed, and above the substrate 14, the thermally-conductive curable liquid resin 16 was filled and cured between the electromagnetic shield members 12a and 12b and the substrate 14 so as to contact the heat-generating electronic components 13a and 13b. Then the electromagnetic shield members were capped with the upper surfaces 12d and a highly thermally-conductive resin film 15a was adhered to a portion of the casing 11a of the smart phone 19 that is facing the upper surfaces 12d of the electromagnetic shield members.

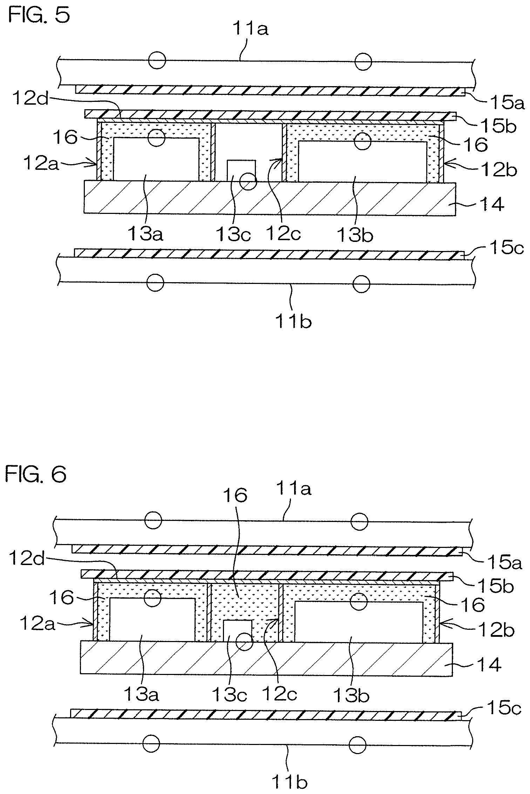

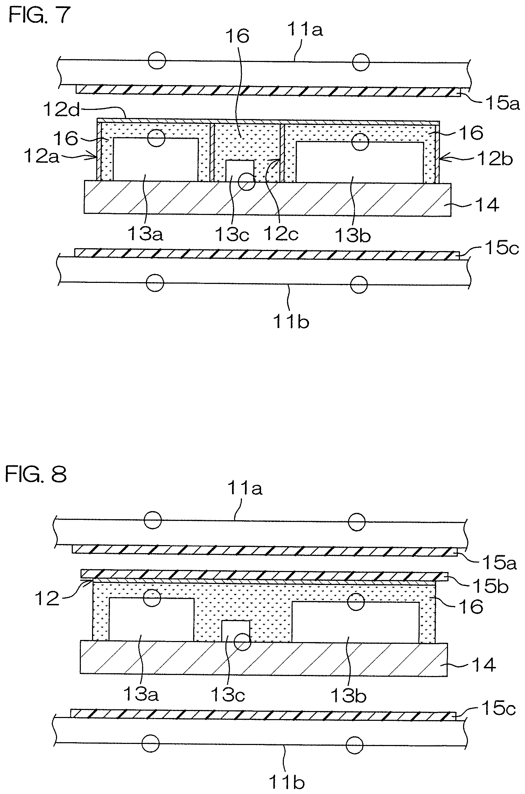

FIG. 5 is a sectional view showing a state where, the upper surfaces 12d of the electromagnetic shield members that surround the heat-generating electronic components 13a and 13b were removed, and the thermally-conductive curable liquid resin 16 was filled and cured between the electromagnetic shield members 12a and 12b and the substrate 14 so as to contact the heat-generating electronic components 13a and 13b. Then the electromagnetic shield members were capped with the upper surfaces 12d and highly thermally-conductive resin film 15a was adhered to the portion of the casing of the smart phone 19 facing the upper surfaces 12d of the electromagnetic shield members and resin film 15b was attached to the upper surfaces 12d of the electromagnetic shield members. That is, in comparison to FIG. 4, the highly thermally-conductive resin films are adhered not just to the casing 11a of the smart phone 19 but also to the upper surfaces 12d of the electromagnetic shield members. The highly thermally-conductive resin films 15a and 15b do not contact each other (the same applies in FIG. 6 and FIG. 8 as well). However, depending on the thicknesses of the highly thermally-conductive resin films 15a and 15b, these may contact each other.

FIG. 6 shows a state where, in comparison to FIG. 5, the thermally-conductive curable liquid resin 16 was also filled and cured in the interior of the electromagnetic shield member 12c surrounding the electronic component 13c between the electromagnetic shield member 12c and the substrate 14. Also, the heat-generating electronic components 13a and 13b are filled with the liquid resin 16. That is, the thermally-conductive curable liquid resin 16 was filled and cured in the interiors of substantially all of the electromagnetic shield members above the substrate 14. The highly thermally-conductive resin films 15a and 15b are respectively adhered to the portion of the casing 11a of the smart phone 19 facing the upper surfaces 12d of the electromagnetic shield members and to the upper surfaces 12d of the electromagnetic shield members.

FIG. 7 shows a state where, in comparison to FIG. 4, the thermally-conductive curable liquid resin 16 was also filled and cured not only on the heat-generating electronic components 13a and 13b but also in the interior of the electromagnetic shield member 12c that is surrounding the electronic component 13c. The highly thermally-conductive resin film 15a is adhered to the portion of the casing 11a of the smart phone 19 facing the upper surfaces 12d of the electromagnetic shield members.

Example 1 corresponds to FIG. 4, Example 2 corresponds to FIG. 5, Example 3 corresponds to FIG. 6, and Example 4 corresponds to FIG. 7. Although Example 5 also corresponds to FIG. 6, it differs in using a highly thermally-conductive resin film with a thickness of 25 μm while Examples 1 to 4 use films of 40 μm thickness.

(Temperature measurement results)

A temperature of the heat-generating electronic component 13a before switching on the power of the smart phone 19 was measured. The temperature may be assumed to be the ambient temperature of the smart phone 19.

The smart phone 19 was started up by turning on the power, was set in the simulated communication state, and simultaneously was set in the HD moving image photography mode. The time from the start of HD moving image photography mode until a halt of the HD moving image photography function of the smart phone 19 by program control (the time until an error display to the effect of: "The camera shall be ended due to heat generation by electronic components." is displayed and the camera is ended forcibly. Hereinafter referred to as the "time until moving image function restriction") and the maximum temperatures of the thermocouples within the time until moving image function restriction were recorded.

The times until moving image function restriction and the maximum temperatures of the respective portions during those times are shown in Table 1.

[Table 1]

Table 1

| Level | | | Comparative Example 1 | Comparative Example 2 | Example 1 | Example 2 | Example 3 | Example 4 | Example 5 |
|---|---|---|---|---|---|---|---|---|---|
| | | | FIG. 2 | FIG. 3 | FIG. 4 | FIG. 5 | FIG. 6 | FIG. 7 | FIG. 6 |
| Liquid resin | 12a interior | | without | with | with | with | with | with | with |
| | 12b interior | | without | with | with | with | with | with | with |
| | 12c interior | | without | without | without | without | with | with | with |
| Thermal diffusion film | 15a | | with | without | with | with | with | with | with |
| | 15b | | with | without | without | with | with | without | with |
| | 15c | | with | without | with | with | with | with | with |
| Thermal conductivity | Thermally-conductive curable resin (W/mK) | | 1.1 | 1.1 | 1.1 | 1.1 | 1.1 | 1.1 | 1.1 |
| | Thermal diffusion film | Thickness direction (W/mK) | 4.9 | 4.9 | 4.9 | 4.9 | 4.9 | 4.9 | 4.9 |
| | | In-surface direction (W/mK) | 1300 | 1300 | 1300 | 1300 | 1300 | 1300 | 1300 |
| Thickness | Thermal diffusion film (μm) | | 40 | 40 | 40 | 40 | 40 | 40 | 25 |
| Measurement condition | Charging mode | | o | o | o | o | o | o | o |
| | Communication (setting: 10 dBM) | | 10.3 | 10.2 | 10.1 | 10.2 | 10.1 | 10.1 | 10.1 |
| | Moving image | | HD | HD | HD | HD | HD | HD | HD |
| | Ambient temperature (°C) | | 24.4 | 24.3 | 24.4 | 24.2 | 24.4 | 24.4 | 24.4 |
| | Time until moving image restriction (minutes) | | 6 | 10 | 15 | 19 | 22 | 18 | 20 |

14

EP 3 119 172 A1

(continued)

| Level | | Comparative Example 1 | Comparative Example 2 | Example 1 | Example 2 | Example 3 | Example 4 | Example 5 |
|---|---|---|---|---|---|---|---|---|
| | | FIG. 2 | FIG. 3 | FIG. 4 | FIG. 5 | FIG. 6 | FIG. 7 | FIG. 6 |
| Thermocouple temperature at time of moving image restriction (°C) | 13a | 97.3 | 72.4 | 66.3 | 63.6 | 61.5 | 64.2 | 62.2 |
| | 13b | 54.8 | 50.2 | 46.5 | 44.4 | 42.8 | 43.7 | 43.0 |
| | 14 | 62.7 | 59.1 | 52.5 | 50.8 | 49.0 | 49.5 | 49.4 |
| | 11a (above 13a) | 45.7 | 63.8 | 32.2 | 32.1 | 30.0 | 33.2 | 31.3 |
| | 11b (above 13b) | 44.9 | 50.3 | 43.1 | 42.2 | 41.7 | 43.6 | 42.2 |
| | 11b (below 13a) | 49.5 | 60.6 | 43.0 | 44.4 | 41.4 | 41.4 | 42.2 |
| | 11b (below 13b) | 48.1 | 49.9 | 46.6 | 47.4 | 43.9 | 43.9 | 44.0 |

(Comparative Example 1)

FIG. 2 is a sectional view showing a state where, without filling the interiors of the electromagnetic shield members with a thermally-conductive curable liquid resin above the substrate 14, and just the highly thermally-conductive resin film 15a is adhered to a portion of the casing 11a of the smart phone 19 facing the upper surfaces 12d of the electromagnetic shield member.

Temperature evaluation in the same manner as in the examples was thus also performed using just the highly thermally-conductive resin film and without using the thermally-conductive curable liquid resin. The evaluation results are shown in Table 1.

(Comparative Example 2)

As shown in FIG. 3, in a state where the upper surfaces 12d of the electromagnetic shield members surrounding the heat-generating electronic components 13a and 13b were removed, the thermally-conductive curable liquid resin 16 was filled and cured above the substrate 14 between the electromagnetic shield members 12a and 12b and the substrate 14 so as to contact the heat-generating electronic components 13a and 13b. Then the electromagnetic shield members were capped with the upper surfaces 12d. However, a highly thermally-conductive resin film was disposed neither on the casing of the smart phone 19 nor on the upper surfaces 12d of the electromagnetic shield members.

Temperature evaluation in the same manner as in the examples was thus also performed using just the thermally-conductive curable liquid resin 16 and without using the highly thermally-conductive resin film. The evaluation results are shown in Table 1.

(Evaluation)

Comparative Example 1 is a structure that does not use the thermally-conductive curable liquid resin and Comparative Example 2 is a structure that does not use the highly thermally-conductive resin film. Each of Examples 1 to 5 is a structure where the thermally-conductive curable liquid resin is used and the heat from the heat-generating electronic components is transferred to the highly thermally-conductive resin film passed through the electromagnetic shield members.

The results of measuring the time until moving image function restriction and the temperatures with the respective structures show that with Comparative Example 1, the function was restricted in six minutes. This is considered to be because although the highly thermally-conductive resin film reduced the temperature of the casing front surface, it did not reduce the temperatures of the heat-generating electronic components.

On the other hand, with Comparative Example 2, the function was restricted in 10 minutes. This result shows that although the time until moving image function restriction was extended by the thermally-conductive curable liquid resin reducing the temperatures of the heat-generating electronic components, but the function was still restricted in the short time of 10 minutes because the heat of the electronic terminal equipment itself was not dissipated to the exterior of the casing.

In comparison to the Comparative Examples, with each of Examples 1 to 5, by the two materials of the thermally-conductive curable liquid resin and the highly thermally-conductive resin film that are combined, the temperatures of the heat-generating electronic components were also reduced and the temperature of the casing surface was also lowered due to diffusion of heat through the highly thermally-conductive resin film so that thermal runaway did not occur and the time until moving image function restriction was extended.

The time until moving image function restriction was extended the most in the state of Example 3 in which the highly thermally-conductive resin film and the thermally-conductive curable resin were used maximally and the time was extended to approximately four times that of Comparative Example 1. Further, the temperatures of the respective heat-generating electronic components were reduced by a maximum of 33.8°C (the difference between the temperatures at the portion 11a, which was 63.8°C in Comparative Example 2 and 30.0°C in Example 3). With other examples, although the time until moving image function restriction was not extended as much as in Example 3, but the time was extended by at least approximately two times or more in comparison to Comparative Examples 1 and 2.

Also, Example 3 and Example 5 differ in the thickness of the highly thermally-conductive resin film and it can be understood that the thicker the thickness of the highly thermally-conductive resin film, the more effective. However, with either thickness, the time until moving image function restriction was extended.

FIG. 8 shows a preferred embodiment where the electromagnetic shield member 12 covers the heat-generating electronic components 13a and 13b from just the upper surfaces thereof and does not cover the peripheries of the heat-generating electronic components 13a and 13b with side walls. Even in such a case, with the two materials of the thermally-conductive curable liquid resin and the highly thermally-conductive resin film being combined as in Examples 1 to 5, the temperatures of the heat-generating electronic components are reduced and the highly thermally-conductive resin film diffuses heat to enable reduction of temperature of the casing surface and extension of the time until the moving image function restriction.

From the above, it is understood that for extension of time until function restriction in an electronic terminal equipment, the combined use of both a highly thermally-conductive resin film and a thermally-conductive curable liquid resin is important, and a processes that the thermally-conductive curable liquid resin transfers the heat from a heat-generating electronic component to a heat dissipation plate or electromagnetic shield member and the highly thermally-conductive resin film diffuses the transferred heat are important. Combination of a highly thermally-conductive resin film and a thermally-conductive curable liquid resin is thus favorable for extension of time until function restriction in an electronic terminal equipment occurs.

Reference Signs List

11a: Casing of electronic terminal equipment
11b: Casing of electronic terminal equipment
12a: Electromagnetic shield member
12b: Electromagnetic shield member
13a: Heat-generating electronic component
13b: Heat-generating electronic component
14: Substrate
15a, 15b, 15c: Highly thermally-conductive resin film
16: Thermally-conductive curable resin
o: Portion at which temperature was measured with a thermocouple

**Claims**

1.  An electronic terminal equipment comprising:

    (a) an electronic substrate mounting, on at least one surface thereof, a heat-generating electronic component and an electromagnetic shield member attached in proximity to the heat-generating electronic component to cover the heat-generating electronic component above at least an upper surface thereof, wherein the electronic substrate is filled with a cured product of a thermally-conductive curable liquid resin between the electromagnetic shield member and the electronic substrate so that the thermally-conductive curable liquid resin is in contact with the heat-generating electronic component, and
    (b) a highly thermally-conductive resin film disposed in contact with an upper surface of the electromagnetic shield member or facing the upper surface thereof, so that the resin film diffuses heat that came up through the thermally-conductive curable liquid resin.

2.  The electronic terminal equipment according to Claim 1, wherein the highly thermally-conductive resin film is a graphite film having anisotropy in thermal conductivity.

3.  The electronic terminal equipment according to Claim 1, wherein the thermally-conductive curable liquid resin is a thermally-conductive curable liquid resin that is cured by moisture or heat.

4.  The electronic terminal equipment according to Claim 1, wherein the electromagnetic shield member surrounds a side wall of the heat-generating electronic component.

5.  The electronic terminal equipment according to Claim 1, wherein the heat-generating electronic component includes at least one of a computing device, a communication control device, and a storage device.

6.  The electronic terminal equipment according to Claim 1, wherein the thermally-conductive curable liquid resin is a thermally-conductive curable liquid resin containing a curable acrylic resin and/or curable polypropylene oxide based resin and a thermally-conductive filler and having a thermal conductivity of not less than 0.5 W/mK.

7.  The electronic terminal equipment according to Claim 1, wherein the highly thermally-conductive resin film has a thermal conductivity in a direction along its surface of not less than 300 W/mK, preferably not less than 600 W/mK, and more preferably not less than 1000 W/mK, and has a thickness of not more than 350 μm, preferably not more than 100 μm, and even more preferably not more than 50 μm.

8. The electronic terminal equipment according to Claim 2, wherein the highly thermally-conductive resin film has a thermal conductivity in a direction along its surface of not less than 300 W/mK, preferably not less than 600 W/mK, and more preferably not less than 1000 W/mK, and has a thickness of not more than 350 μm, preferably not more than 100 μm, and even more preferably not more than 50 μm.

9. A method for assembling an electronic terminal equipment comprising:

(a) filling a thermally-conductive curable liquid resin between an electromagnetic shield member and an electronic substrate so that the thermally-conductive curable liquid resin is in contact with a heat-generating electronic component that is mounted on at least one surface of the electronic substrate, wherein the electromagnetic shield member is disposed in proximity to the heat-generating electronic component so as to cover the heat-generating electronic component above at least an upper surface thereof, and
(b) arranging a highly thermally-conductive resin film to diffuse heat that came up through the thermally-conductive curable liquid resin, wherein the resin film is disposed in contact with or facing an upper surface of the electromagnetic shield member.

FIG. 1

13a   13c   13b

19

14

12a   12c   12b

11b

FIG. 2

11a

12d

15a
15b

12a

12b

14

13a   13c   12c   13b

15c

11b

FIG. 3

FIG. 4

## FIG. 5

11a

12d

16

12a

15a
15b
16
12b
14

13a    13c  12c   13b

15c

11b

## FIG. 6

16    11a

12d

16

12a

15a
15b
16
12b
14

13a    13c  12c   13b

15c

11b

FIG. 7

FIG. 8

FIG. 9

## INTERNATIONAL SEARCH REPORT

| | International application No. |
|---|---|
| | PCT/JP2015/056701 |

**A. CLASSIFICATION OF SUBJECT MATTER**
*H05K9/00*(2006.01)i, *H05K7/20*(2006.01)i

According to International Patent Classification (IPC) or to both national classification and IPC

**B. FIELDS SEARCHED**

Minimum documentation searched (classification system followed by classification symbols)
H05K9/00, H05K7/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-210940 A (Mitsubishi Electric Corp.), 10 August 2006 (10.08.2006), claims; paragraphs [0001] to [0002], [0018], [0037] to [0038]; fig. 6 (Family: none) | 1-9 |
| Y | JP 2010-171030 A (Kaneka Corp.), 05 August 2010 (05.08.2010), entire text; all drawings & JP 2015-19085 A | 1-9 |
| A | JP 2012-015548 A (Tatsuta Electric Wire & Cable Co., Ltd.), 19 January 2012 (19.01.2012), entire text; all drawings (Family: none) | 1-9 |

☐ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 29 May 2015 (29.05.15) | 09 June 2015 (09.06.15) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011126262 A
- JP 2002305271 A
- JP 2011165699 A
- JP 2008153704 A
- JP 2006319134 A